# EUROPEAN PATENT SPECIFICATION

(11) **EP 0 641 146 B1**
(45) Date of publication and mention of the grant of the patent: **06.10.1999**
(21) Application number: 93306805.8
(22) Date of filing: 26.08.1993
(51) Int. Cl.: H05B 6/32, C30B 13/28

(54) **Magnetic suspension melting apparatus**
Induktionsschmelzofen mit magnetischer Aufhängung
Four à induction pour fusion à suspension magnétique

(43) Date of publication of application: 01.03.1995
(73) Proprietor: INDUCTOTHERM CORP., Rancocas New Jersey 08073 (US)
(72) Inventor: Fishman,Oleg S., Maple Glen, Pennsylvania 19002 (US); Lampi,Rudolph K., Tabernacle, New Jersey 08088 (US); Peysakhovich,Vitaly, Moorestown, New Jersey 08057 (US)
(74) Representative: Lyons, Andrew John

(56) References cited:
- EP-A- 0 395 286
- BE-A- 665 626
- FR-A- 1 266 863
- FR-A- 1 358 438
- FR-A- 2 497 050
- GB-A- 1 011 231
- US-A- 3 702 368
- US-A- 5 003 551
- JOURN. OF THE ELECTROCHEM. SOC. no. 99 , 1952 , PHILADELPHIA, USA pages 205 - 211 P.H. BRACE AT AL. 'A Technique for Eliminating Crucibles in Heating and Melting of Metals'

## Description

### Field of the Invention

The present invention relates to magnetic suspension melting, sometimes referred to as MSM, in which metal is melted by electromagnetic induction without the need for a crucible. Instead, a magnetic field is used to contain the melt.

### Background of the Invention

In the manufacture of metal castings it is important to avoid contamination of the metal with non-metallic inclusions. These inclusions are usually oxide phases, and are usually formed by reaction between the metals being melted and the crucible in which they are melted. It has long been an aim of metal casters to avoid such contamination by using crucibles which have minimum reactivity with the melts. However, some alloys, in particular nickel-based superalloys, which may contain substantial amounts of aluminum, titanium, or hafnium, react vigorously with oxide crucibles and form inclusions during melting.

Heretofore there have been two main methods of avoiding contamination from a crucible in metal smelting. One method is "cold-crucible" melting, in which a water cooled copper crucible is used. The metal charge, which may be melted by induction, electric arc, plasma torch, or electron beam energy sources, freezes against the cooled copper crucible wall. Thereafter, the liquid metal is held within a "skull" of solid metal of its own composition, and does contact the crucible wall.

Another method is levitation melting. In levitation melting, a quantity of metal to be melted is electromagnetically suspended in space while it is heated. U.S. Patent No. 2,686,864 to Wroughton et al. and U.S. Patent No. 4,578,552 to Mortimer show methods of using induction coils to levitate a quantity of metal and heat it inductively.

Cold crucible melting and levitation melting necessarily consume a great deal of energy. In the case of cold-crucible melting, a substantial amount of energy is required merely to maintain the pool of molten metal within the skull, and much of the heating energy put into the metal must be removed deliberately just to maintain the solid outer portion. With levitation melting, energy is required to keep the metal suspended. In addition, as compared to the surface of a molten bath in a conventional crucible, levitation melting causes the quantity of metal to have a large surface area, which is a source of heat loss by radiation. Additional energy is required to maintain the metal temperature.

For alloys which are mildly reactive with crucibles, such as the nickel-base superalloys referred to above, a process called the "Birlec" process has been used. This process was developed by the Birmingham Electric Company in Great Britain. In the Birlec process, induction is used to melt just enough metal to pour one casting. Instead of pouring metal from the crucible conventionally, however, by tilting it and allowing the melt to flow over its lip, the crucible has an opening in its bottom covered with a "penny" or "button" of charge metal. After the charge is melted, heat transfer from the molten charge to the penny melts the penny, allowing the molten metal to fall through the opening into a waiting casting mold below.

By using a small quantity of metal with the proper induction melting frequency and power in the Birlec process, the metal can be "haystacked," or partially levitated, and held away from the crucible sides for much of the melting process, thus minimizing, although not eliminating, contact with the crucible sidewall. Such a process is in use today for the production of single crystal investment castings for the gas turbine industry.

The use of "haystacking" to melt refractory and titanium alloys was tried by the U.S. Army at Watertown Arsenal in the 1950s, using carbon crucibles, but was not successful in eliminating carbon contamination from the crucible, and there was no satisfactory method of controlling the pouring temperature of the metal to the accuracy desired for aerospace work.

These problems have been solved to a large extent by placing the metal charge to be melted within an induction coil, which exerts on the metal an electromagnetic force which is greater near the bottom of the charge than near the top of the charge. The charge is free-standing on a support plate, which has an opening through it through which liquid metal may drain into a mold or other container placed below the support plate as the charge melts. The support is cooled to a preselected temperature. This technique, sometimes referred to as magnetic suspension melting, or MSM, is disclosed in U.S. Patents 5,014,769 and 5,033,948, assigned to the same assignee as the present invention. Familiarity with the MSM process disclosed in those two patents to those skilled in the art is assumed, and that process will not be described in detail herein.

It has been found, however, that while the MSM technique works well for many metals, it is not so effective for certain high-melting temperature metals such as steel, titanium and superalloys. It is believed that, because of magnetohydrodynamic flows within the molten metal, the metal develops instabilities which cause the charge of molten metal to collapse prematurely, before the entire charge becomes molten. In such cases, the molten metal runs off the side of the charge, rather than through the opening in the support plate, as it is intended to.

The present invention solves the problem of instabilities in the molten metal and makes the MSM technique effective for the melting of steels and superalloys.

FR-A-2 497 059 (or US-A-4 432 093) discloses an apparatus for inductively melting a quantity of metal which is held in a cold sheath or shroud, comprising a cylindrical side wall composed of a plurality of juxtaposed segments, the device having supplementary electromagnetic confinement of the conducting portions of the charge so that its electrically conducting portion is kept away from the inner face of the shroud sidewall.

### Summary of the Invention

The present invention is directed to apparatus for inductively melting a quantity of metal without a container. The apparatus comprises a first induction coil having a plurality of turns defining a volume for receiving a quantity of metal, the first induction coil being adapted to exert an electromagnetic force on the metal thereby containing the metal within the defined volume to avoid the need for a container to confine the metal within the apparatus, and a second induction coil having a plurality of turns at substantially right angles to the turns of the first induction coil, the second induction coil being disposed within said volume coaxial with the first induction coil. Both the first and second induction coils have means thereon for connecting the coils to at least one power supply means for energizing the first and second induction coils. Support means are provided for supporting the metal from below. The support means has an opening through it. The support means includes a raised segmented rim around substantially the entire periphery thereof. The support means is maintained at a preselected temperature.

In an alternate embodiment, means are also provided for imparting rotational motion to the support means.

### Description of the Drawings

For the purpose of illustrating the invention, there is shown in the drawings a form which is presently preferred; it being understood, however, that this invention is not limited to the precise arrangements and instrumentalities shown.

Figure 1 is a side elevational view, in section, showing the major components of one form of apparatus according to the present invention.

Figure 2 is a sectional view of the apparatus of Figure 1, taken along the lines 2-2 in Figure 1.

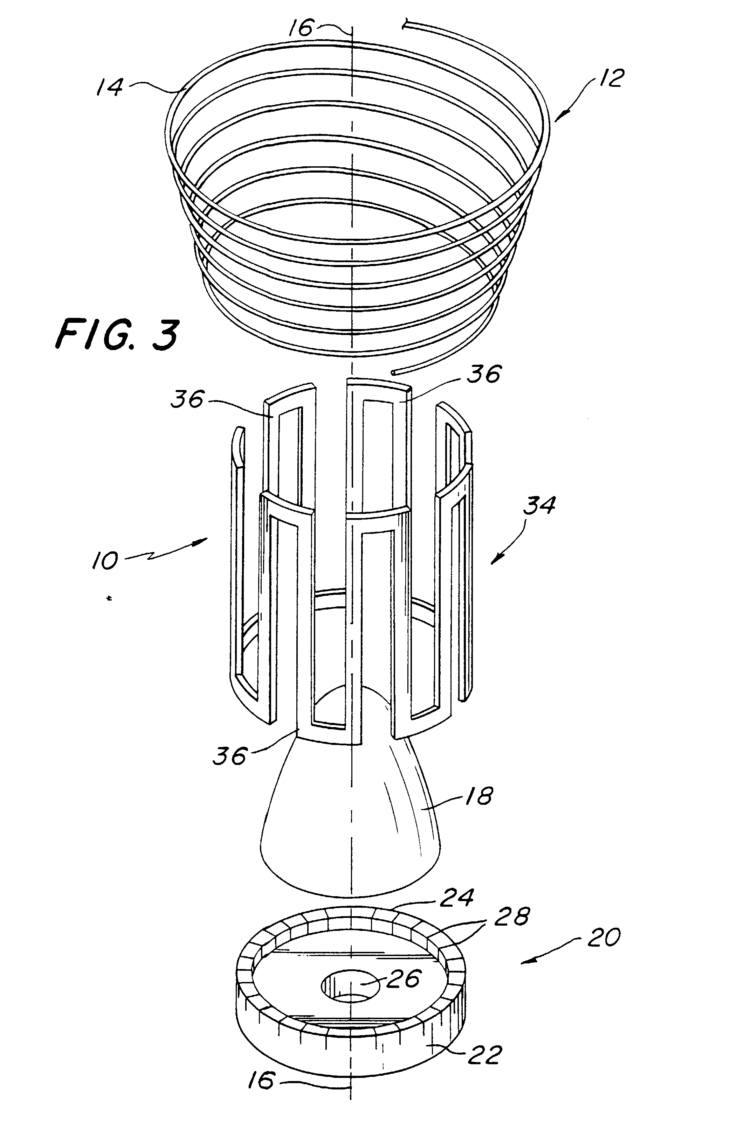

Figure 3 is an exploded view of the apparatus of Figure 1.

Figure 4 is composed of Figs. 4A and 4B illustrating alternate embodiments for imparting rotation to reduce surface instabilities in the molten metal.

### Description of the Invention

Referring now to the drawings, wherein like numerals indicate like elements, there is shown in the figures a magnetic suspension melting apparatus 10 according to the invention. (Reference may also be made to U.S. patents 5,014,769 and 5,033,948, the disclosures of which are incorporated herein by reference.) Apparatus 10 comprises a first induction coil 12, which has a plurality of helical turns 14 centered about a central axis 16. First induction coil 12 is, for purposes of this invention, constructed in known manner. First induction coil 12 includes connector means for connecting coil 12 to a high-frequency power supply (not shown) for energizing coil 12 in known manner with a high-frequency alternating current. The high-frequency alternating current in first induction coil 12 induces currents to flow in metal to be melted. The induced currents in the metal heat and eventually melt the metal, as is well-understood in the art.

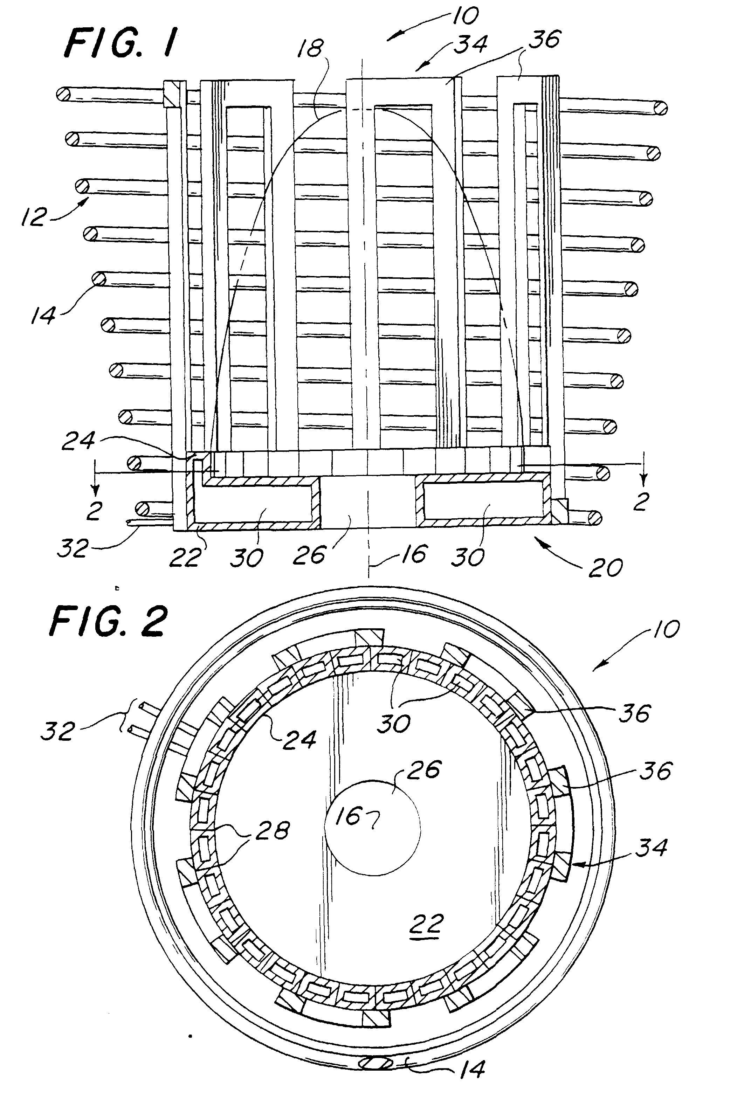

The turns 14 of coil 12 define an interior volume in which is received a quantity, or charge, of metal 18, shown in phantom in Figure 1, to be melted by the apparatus 10. Metal charge 18 is supported by a support means 20 in the form of an annular plate 22 which has a raised annular rim portion 24 around substantially the entire circumference of plate 22. Support means 20 has a central opening 26 therethrough, through which molten metal 18 runs by gravity into a mold or other container (not shown) after being melted by first induction coil 12.

Rim portion 24 of support means 20 is preferably not continuous but is segmented. That is, the rim is provided with a plurality of gaps or slots 28 at angularly-spaced intervals. These gaps or slots 28 allow the magnetic field generated by the first induction coil 12 to more easily couple to and penetrate the metal charge 18. A typical flat plate, without a raised rim, cannot be made slotted (since to do so would enable molten metal to run through the slots), and, accordingly, magnetically couples to the induction coil. Especially in cases where the metal charge 18 has high resistivity, a typical flat plate attenuates the magnetic field in the lower sections of the charge, where the magnetic supporting force needs to be the strongest. In contrast, the slotted rim portion 24 of support means 20 enables the maximum amount of magnetic force to be applied to the lower sections or charge 18 with minimum attenuation by the support means 20. This supports the molten metal and constrains it to drain through the central opening 26, as desired. The gaps or slots 28 serve to break up currents induced in support means by first induction coil 12, so that very little of the energy of the magnetic field from first induction coil 12 is lost in coupling to the support means 20.

Support means 20 is preferably, although not necessarily, provided with internal cavities 30 through which water or other suitable coolant can be circulated to chill support means 20. As in the conventional MSM process, it is desired that support means 20 be kept at a relatively low temperature compared to the metal charge 18 so that metal in contact with and closely adjacent support means 20 will remain solid. Suitable conduits 32 can be provided for providing a flow of coolant to and from support means 20 and a source of coolant (not shown).

A second induction coil 34 is located between turns 14 of the first induction coil 12 and the metal charge 18. That is, second induction coil 34 is located within the interior volume defined by first induction coil 12. Second induction coil 34 has a plurality of turns 36 which are arranged at substantially right angles to the turns 14 of first induction coil 12. Thus, where the turns 14 of first induction coil 12 are generally horizontally disposed, the turns 36 of second induction coil 34 are generally vertically disposed. This gives second induction coil 34 a substantially cylindrical shape. Second induction coil 34 is also provided with suitable connectors for connecting it to a power supply (not shown), which may but need not be the same power supply to which first induction coil 12 is connected. Second induction coil 34 encompasses, but is spaced slightly away from, support means 20, so that both support means 20 and metal charge 18 are within the interior volume defined by second induction coil 34.

Second induction coil 34 is preferably excited by a high-frequency power supply (not shown), which causes second induction coil 34 to induce vertically-orientated electrical currents into the surface of metal charge 18 as the metal is being melted by first induction coil 12. This helps to reduce surface instabilities in the molten metal which could tend to adversely affect melting and subsequent flow of molten metal from central opening 26 in support means 20. That is, the surface of the molten metal tends to become smoother, and runoff of molten metal off the side of support means is prevented.

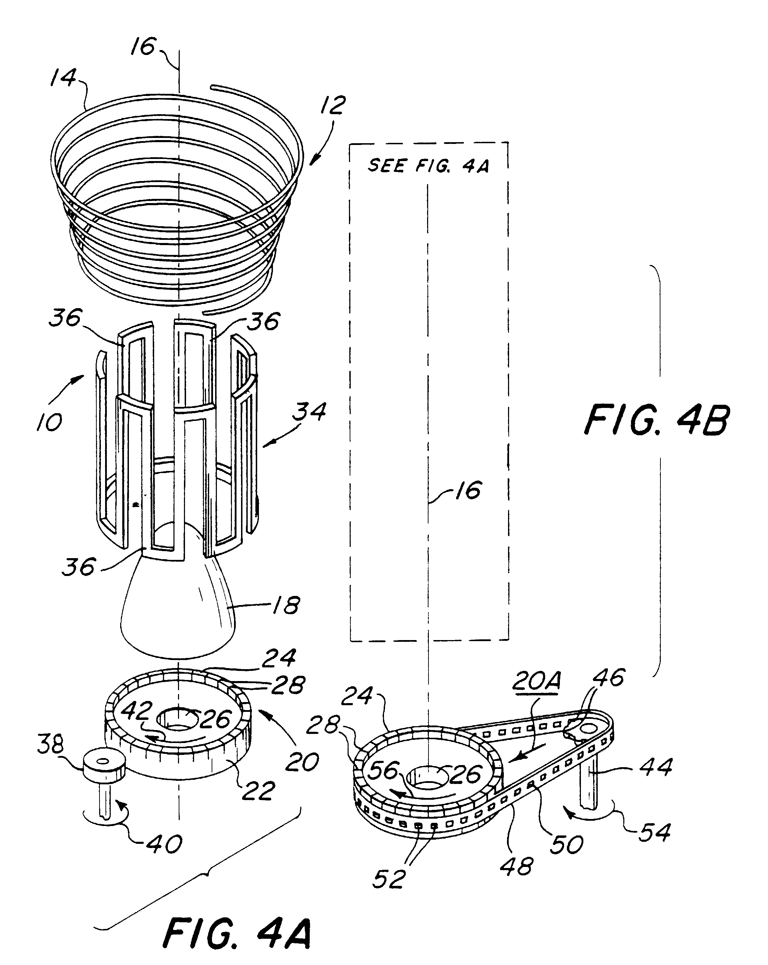

To further reduce surface instabilities and stabilize the melting process, support means 20 may be rotated about axis 16. Any suitable structure may be used to rotate support means 20 relative to the remainder of apparatus 10, or the entire apparatus 10, including support means 20, may be rotated. Suitable structures for rotating support means 20 are shown in Fig. 4 which is composed of Figs. 4A and 4b. Fig. 4A illustrates a first embodiment comprising a wheel 38 which is rotated in a particular direction 40; e.g., counterclockwise as shown, and which frictionally engages and imparts rotational movement to the support means 20 in a clockwise direction 42 about axis 16. Fig. 4B illustrates a second embodiment having many of the elements of Fig. 4A, but for the sake of clarity does not show elements 14, 18 and 26 shown in Fig. 4A. The embodiment of Fig. 4B comprises a sprocket wheel 44 having sprockets 46, a chain 48 having separations 50 serving as links, and a support means 20A which is the same as support means 20 except that it has sprockets 52 uniformly distributed about the outside circumference. The sprocket wheel 44 is rotated in a particular direction 54; e.g., clockwise as shown, and its sprockets 46 engage links 50 and cause the rotation of chain 48. The links of the chain 48 are also engaged by sprockets 52 which in turn impart rotational movement of support means 20A in a clockwise direction 56 about axis 16. Regardless of the actual means employed to impart rotational movement to support means 20, the centrifugal force imparted to the molten metal 18 as support means 20 is rotated counteracts surface instabilities generated by the melting process and helps to smooth the surface of the molten metal.

The present invention may be embodied in other specific forms without departing from the essential attributes thereof and, accordingly, reference should be made to the appended claims as indicating the scope of the invention.

## Claims

1. Apparatus for inductively melting a quantity of metal without a container, comprising a first induction coil (12) having means thereon for connecting it to a power supply means for energising the first induction coil, the first induction coil also having a plurality of turns (14) defining a volume for receiving a quantity of metal (18), the first induction coil being adapted to exert an electromagnetic force on the metal thereby containing the metal within the defined volume to avoid the need for a container to confine the metal within the apparatus, a second induction coil (34) having means thereon for connecting it to a power supply means for energising the second induction coil, the second induction coil also having a plurality of turns (36) at substantially right angles to the turns of the first induction coil, the second induction coil being disposed within said volume coaxial with the first induction coil, a support means (20) for supporting the metal from below and having an opening therethrough, the support means including a raised segmented rim (24) around substantially the entire periphery thereof, and means for maintaining the support means at a preselected temperature.

2. Apparatus according to claim 1, further comprising means (38 or 44,46,48,50,52) for imparting rotational motion to the support means (20).

3. Apparatus according to claim 1 or 2, wherein the first induction coil (12) is substantially helical in configuration.

4. Apparatus according to claim 1, 2 or 3 wherein the second induction coil (34) is substantially cylindrical in configuration.

5. Apparatus as claimed in any one of claims 1 to 4, wherein the first induction coil (12), second induction coil (34), and support means (20) are all disposed along a common axis (16).

6. Apparatus as in claim 5, wherein the support means (20) is rotated about the common axis.

7. Apparatus as claimed in claim 6, wherein the common axis (16) is central.

8. Apparatus as claimed in claim 7, wherein the support means (20) is annular and has a centrally-located opening therethrough.

## Patentansprüche

1. Vorrichtung zum induktiven Schmelzen einer Metallmenge ohne Behälter, aufweisend eine erste Induktionsspule (12) mit Mitteln darauf, um sie mit einer Stromversorgungseinrichtung zum Erregen der ersten Induktionsspule zu verbinden, wobei die erste Induktionsspule auch eine Mehrzahl von Windungen (14) hat, die ein Volumen zum Aufnehmen einer Metallmenge (18) definieren, wobei die erste Induktionsspule angepaßt ist, um eine elektromagnetische Kraft auf das Metall auszuüben und dadurch das Metall in dem definierten Volumen zu halten, um die Notwendigkeit für einen Behälter zu vermeiden, um das Metall in der Vorrichtung zu begrenzen,
eine zweite Induktionsspule (34) mit Mitteln darauf, um sie mit einer Stromversorgungseinrichtung zum Erregen der zweiten Induktionsspule zu verbinden, wobei die zweite Induktionsspule ebenfalls eine Mehrzahl von Windungen (36) in im wesentlichen rechten Winkeln zu den Windungen der ersten Induktionsspule hat, wobei die zweite Induktionsspule in dem Volumen koaxial zu der ersten Induktionsspule angeordnet ist,
eine Stützeinrichtung (20) zum Unterstützen des Metalls von unten und mit einer Durchgangsöffnung, wobei die Stützeinrichtung einen erhöhten geteilten Rand (24) um im wesentlichen seine ganze Peripherie herum enthält, und
eine Einrichtung, um die Stützeinrichtung auf einer vorgewählten Temperatur zu halten.

2. Vorrichtung gemäß Anspruch 1, die weiterhin eine Einrichtung (38 oder 44, 46, 48, 50, 52) enthält, um der Stützeinrichtung (20) eine drehende Bewegung zu verleihen.

3. Vorrichtung gemäß Anspruch 1 oder 2, bei welcher die erste Induktionsspule (12) im wesentlichen schraubenförmig in ihrer Anordnung ist.

4. Vorrichtung gemäß Anspruch 1, 2 oder 3, bei welcher die zweite Induktionsspule (34) im wesentlichen zylindrisch in ihrer Anordnung ist.

5. Vorrichtung gemäß einem der Ansprüche 1 bis 4, bei welcher die erste Induktionsspule (12), die zweite Induktionsspule (34) und die Stützeinrichtung (20) alle entlang einer gemeinsamen Achse (16) angeordnet sind.

6. Vorrichtung gemäß Anspruch 5, bei welcher die Stützeinrichtung (20) um die gemeinsame Achse gedreht wird.

7. Vorrichtung gemäß Anspruch 6, bei welcher die gemeinsame Achse (16) zentral ist.

8. Vorrichtung gemäß Anspruch 7, bei welcher die Stützeinrichtung (20) ringförmig ist und eine zentral angeordnete Durchgangsöffnung hat.

## Revendications

1. Dispositif pour faire fondre par induction une certaine quantité de métal à l'intérieur d'un récipient, le dispositif comprenant : une première bobine d'induction (12) comportant des moyens pour la relier à des moyens d'alimentation en puissance électrique pour mettre sous tension la première bobine d'induction, cette première bobine d'induction présentant également une pluralité de spires (14) définissant un volume pour recevoir une certaine quantité de métal (18), la première bobine d'induction étant apte à exercer une force électromagnétique sur le métal, de manière à contenir le métal dans le volume défini, afin d'éviter d'avoir recours à un récipient pour confiner le métal à l'intérieur du dispositif ; une deuxième bobine d'induction (34) comportant des moyens pour la relier à des moyens d'alimentation en puissance électrique pour mettre sous tension la deuxième bobine d'induction, cette deuxième bobine d'induction présentant également une pluralité de spires (36) sensiblement à angle droit par rapport aux spires de la première bobine d'induction, la deuxième bobine d'induction étant disposée à l'intérieur dudit volume coaxialement à la première bobine d'induction ; des moyens de support (20) pour supporter le métal par en dessous et présentant une ouverture traversant les moyens de support, comprenant un bord relevé et segmenté (24) sensiblement autour de la totalité de leur périphérie ; et des moyens pour maintenir les moyens de support à une température présélectionnée.

2. Dispositif selon la revendication 1, comprenant en outre des moyens (38 ou 44, 46, 48, 50, 52) pour provoquer le déplacement en rotation des moyens de support (20).

3. Dispositif selon la revendication 1 ou 2, dans lequel la première bobine d'induction (12) présente une configuration sensiblement hélicoïdale.

4. Dispositif selon la revendicaton 1, 2 ou 3, dans lequel la deuxième bobine d'induction (34) présente une configuration sensiblement cylindrique.

5. Dispositif selon l'une quelconque des revendications 1 à 4, dans lequel la première bobine d'induction (12), la deuxième bobine d'induction (32), et les moyens de support (20) sont tous disposés le long d'un axe commun (16).

6. Dispositif selon la revendication 5, dans lequel les moyens de support sont entraînés en rotation autour de l'axe commun.

7. Dispositif selon la revendication 6, dans lequel l'axe commun (16) est central.

8. Dispositif selon la revendication 7, dans lequel les moyens de support (20) sont annulaires et comportent une ouverture disposée au centre et les traversant.
